# EUROPÄISCHE PATENTSCHRIFT

(11) **EP 1 756 870 B1**
(45) Veröffentlichungstag und Bekanntmachung des Hinweises auf die Patenterteilung: **10.09.2008**
(21) Anmeldenummer: 05739599.8
(22) Anmeldetag: 13.05.2005
(51) Int. Cl.: H01L 31/0304, H01L 31/0224, H01L 21/04

(54) **TRANSPARENTER KONTAKT UND VERFAHREN ZU DESSEN HERSTELLUNG**
TRANSPARENT CONTACT AND METHOD FOR THE PRODUCTION THEREOF
CONTACT TRANSPARENT ET PROCEDE DE REALISATION

(30) Priorität: 14.05.2004 DE 102004023977
(43) Veröffentlichungstag der Anmeldung: 28.02.2007
(73) Patentinhaber: Fraunhofer-Gesellschaft zur Förderung der angewandten Forschung e.V., 80686 München (DE)
(72) Erfinder: DIMROTH, Frank, 79115 Freiburg (DE)
(86) Internationale Anmeldenummer: PCT/EP2005/005249
(87) Internationale Veröffentlichungsnummer: WO 2005/112132

(56) Entgegenhaltungen:
- EP-A- 1 069 622
- US-A- 4 032 951
- WANG C A ET AL: "Monolithically series-interconnected GaInAsSb/AlGaAsSb/GaSb thermophotovoltaic devices with an internal backsurface reflector formed by wafer bonding" APPLIED PHYSICS LETTERS, AMERICAN INSTITUTE OF PHYSICS. NEW YORK, US, Bd. 83, Nr. 7, 18. August 2003 (2003-08-18), Seiten 1286-1288, XP012035787 ISSN: 0003-6951
- BIEFELD R M: "The metal-organic chemical vapor deposition and properties of III-V antimony-based semiconductor materials" MATERIALS SCIENCE AND ENGINEERING R: REPORTS, ELSEVIER SEQUOIA S.A., LAUSANNE, CH, Bd. 36, Nr. 4, 15. März 2002 (2002-03-15), Seiten 105-142, XP004343704 ISSN: 0927-796X

## Beschreibung

Die Erfindung betrifft einen transparenten Kontakt und ein Verfahren zu dessen Herstellung. Solche Kontakte werden in Halbleiterbauelementen, insbesondere in optoelektronischen Bauelementen eingesetzt.

In den letzten Jahren wurde eine große Anzahl an Halbleiterbauelementen entwickelt und kommerzialisiert, welche in infraroten Spektralbereich zwischen 1 und 10 µm arbeiten. Beispielhaft seien thermophotovoltaische Zellen, Photodetektoren, Gassensoren, Laser- und Leuchtdioden genannt. Diese Bauelemente bestehen meist aus binären, ternären oder quaternären Verbindungshalbleitern der dritten und fünften Hauptgruppe des Periodensystems. Beispielhaft seien Galliumantimonid (GaSb), Indiumarsenid (InAs) oder Mischkristalle wie GaₓIn₁₋ₓAs_{y}Sb_{1-y} genannt. Dieses letztgenannte Material weist direkte Bandlücken zwischen 0.1 eV und 0.7 eV sowie Gitterkonstanten zwischen 0,606 nm (6,06 Å) und 0,648 nm (6,48 Å) auf.

All diesen Bauelementen ist das Problem zu eigen, dass über die Oberfläche des Bauelementes einerseits elektrischer Strom, andererseits aber auch Photonen ein- bzw. ausgekoppelt werden müssen. Nach dem Stand der Technik erfolgt die Einkopplung des elektrischen Stromes über einen metallischen Kontakt, welcher zwar geringe Übergangswiderstände zum Halbleitermaterial aufweist, jedoch für ein- oder austretende Photonen nicht transparent ist und hohe Reflexionsverluste verursacht.

Weiterhin ist bekannt, dass bestimmte Verbindungshalbleiter, wie beispielsweise Aluminiumgalliumantimonid, nur sehr schlecht durch metallische Kontakte kontaktierbar sind. So führen bei dem oben genannten Halbleitermaterial direkt aufgebrachte Metallkontakte zu hohen Übergangswiderständen und Haftungsproblemen. Das Dokument EP-A-1 069622 beschreibt ein Verfahren zur Herstellung eines Kontaktes auf einem Substrat.

Aus C.A. Wang, R.K. Huang, D.A. Shiau, M.K. Connors, P.G. Murphy, P.W. O'Brien, A.C. Anderson, D.M. DePoy, G. Nichols und M.N. Palmisiano, Monolithically Series-Interconnected GalnAsSb/AlGaAsSb/GaSb Thermophotovoltaic Devices with an Internal backsurface reflector formed by Wafer bonding, Appl. Phys. Lett. 83" (2003) 1286 sowie aus C.W. Hitchcock, R.J. Gutmann, J.M. Borrego, I.B. Bhat und G.W. Charache, Antimonide-based Devices for Thermophotovoltaic Applications, IEEE Trans. Electron Devices 46 (1999) 2154 ist bekannt, thermophotovoltaische Zellen aus GaSb und GaInAsSb mit einer transparenten AlGaAsSb-Schicht zu versehen und darauf eine hochdotierte Kontaktschicht aus GaSb anzubringen. Durch die großflächige GaSb-Schicht kann der Kontaktwiderstand und damit die elektrischen Verluste des Bauelementes erheblich vermindert werden. Nachteilig an dieser Ausführungsform ist jedoch, dass die GaSb-Kontaktschicht einen Teil der Photonen mit einer Wellenlänge unter 1720 nm absorbiert. Dabei entstehen in der Kontaktschicht Minoritätsladungsträger, welche von der AlGaAsSb-Schicht reflektiert werden und für die Stromgeneration in der Thermophotovoltaikzelle nicht mehr zur Verfügung stehen. Als weiteren Nachteil erhöht die ganzflächig aufgebrachte GaSb-Kontaktschicht die Reflexion des einfallenden Lichtes. Somit wird auch der optische Wirkungsgrad der Zelle vermindert.

Auch für oberflächenemittierende langwellige Laser, wie z.B. GaSb-basierende Quantentopflaser mit einer Wellenlänge > 2 µm, wird üblicherweise eine hochdotierte, nichtstrukturierte GaSb-Kontaktschicht auf einer transparenten Barrierenschicht aus AlGaAsSb verwendet. Obgleich die GaSb-Kontaktschicht in diesem Wellenlängenbereich das emittierte Licht kaum noch absorbiert, kommt es auf Grund des niedrigen Brechungsindex von AlGaAsSb im Vergleich zu GaSb zu optischen Reflexionsverlusten, welche den Gesamtwirkungsgrad des Bauteils vermindern.

Die Aufgabe der vorliegenden Erfindung besteht demnach darin, einen transparenten, niederohmigen Kontakt anzugeben, welcher sowohl optische Reflexions- und Absorptionsverluste als auch elektrische Widerstandsverluste verringert. Weiterhin besteht die Aufgabe darin, ein optoelektronisches Bauelement anzugeben, welches im Vergleich zum Stand der Technik einen gesteigerten Wirkungsgrad aufweist.

Die Aufgabe wird erfindungsgemäß gelöst durch ein Verfahren zur Herstellung eines transparenten, niederohmigen Kontaktes auf einem Substrat, bei welchem eine Schichtenabfolge aus einer ersten Schicht, einer zweiten Schicht und einer dritten Schicht auf das Substrat aufgebracht wird, wobei die erste Schicht aus einem AlₙGa₁₋ₙAsₘSb₁₋ₘ, enthaltenden Material hergestellt wird, worauf in vorbestimmten Raumbereichen eine InₓGa₁₋ₓAs_{y}Sb_{1-y} enthaltende Schicht aufgebracht wird und die InₓGa₁₋ₓAs_{y}Sb₁₋ y enthaltenden Bereiche der zweiten Schicht zumindest teilweise mit einer Schicht aus einem Metall oder einer Legierung versehen werden, wobei die Parameter x und y aus dem Intervall von 0.9 bis 1.0, der Parameter n aus dem Intervall von 0.3 bis 1 und der Parameter m aus dem Intervall von 0.0 bis 0.1 ausgewählt sind.

Bei dem erfindungsgemäß verwendeten Substrat handelt es sich um eine binäre, ternäre oder quaternäre Verbindung der dritten und fünften Hauptgruppe des Periodensystems. Besonders bevorzugt handelt es sich um ein Substrat, welches GaSb und/oder InAs und/oder GaInAsSb und/oder AlGaAsSb enthält. Das Substrat kann dabei homogen aus einem Material hergestellt sein oder aber eine Schichtenabfolge aus mehreren homo- oder heteroepitaktisch abgeschiedenen Materialien aufweisen.

Erfindungsgemäß wurde erkannt, dass der elektrische Widerstand zwischen einem Metallkontakt und einem Halbleitermaterial erheblich vermindert werden kann, wenn die Kontaktschicht, welche nach dem bisherigen Stand der Technik aus GaSb hergestellt wurde, aus einem InₓGa₁₋ₓAs_{y}Sb enthaltenden Material gefertigt wird. Gleichzeitig lässt sich dieses Material in einfacher Weise nur auf einer Teilfläche des Halbleitersubstrates aufbringen, so dass die Transmission von Photonen durch die Kontaktschicht nicht beeinträchtigt wird.

Auch der erfindungsgemäße Kontakt verwendet eine nach dem Stand der Technik bekannte AlₙGa₁₋ₙAsₘSb₁₋ₘ -Barrierenschicht um die darunter liegende Bauelementstruktur zu passivieren. Auf diesen Barrierenschichten lassen sich jedoch keine niederohmigen Kontakte herstellen. Weiterhin neigt die aluminiumhaltige Barriereschicht zur Oxidation, wodurch die Haftung und der Übergangswiderstand der Kontakte weiter verschlechtert werden.

Die nun vorgeschlagenen InₓGa₁₋ₓAs_{y}Sb_{1-y} enthaltenden Kontaktschichten erlauben aufgrund Ihrer Bandstruktur eine im Vergleich zum Stand der Technik verbesserte Kontaktierung des Halbleitersubstrats durch die AlₙGa₁₋ₙAsₘSb₁₋ₘ -Barrierenschicht hindurch. Weiterhin können auf dem nun vorgeschlagenen Material der Kontaktschicht ohmsche Kontakte mit sehr geringem Widerstand hergestellt werden. So beträgt beispielsweise die Höhe der Schottky-Bariere eines Goldkontaktes auf n-dotiertem InAs lediglich 0,01 eV. Ähnlich gute Ohmsche Kontakte lassen sich auf p-dotiertem InAsSb durch Schichtkontakte aus Ti/Ni/Au realisieren. Somit ist der gesamte elektrische Widerstand im Vergleich zum Stand der Technik erniedrigt und der elektrische Wirkungsgrad des Bauelementes wird insbesondere bei hohen Stromdichten erhöht.

Als ein weiterer Vorteil der erfindungsgemäßen Kontaktschicht wird angesehen, dass das InₓGa₁₋ₓAs_{y}Sb_{1-y}-Material durch Dotierstoffe n- oder p-leitend herstellbar ist. Somit kann die Kontaktschicht an das zugrunde liegende Bauelement angepasst werden. Als Dotierstoff eignet sich insbesondere Silizium und/oder Schwefel und/oder Tellur und/oder Kohlenstoff und/oder Magnesium und/oder Zink und/oder Selen.

Eine besonders einfache elektrische Kontaktierung der Kontaktschicht ergibt sich, wenn auf die Kontaktschicht eine Schicht aus einem Metall oder einer Legierung aufgebracht wird, welche Gold und/oder Titan und/oder Platin und/oder Nickel und/oder Palladium und/oder Zink und/oder Silber und/oder Germanium enthält.

In Abhängigkeit des für die InₓGa₁₋ₓAs_{y}Sb_{1-y}-Kontaktschicht gewählten Materials wird der Fachmann aus den genannten Metallen dass jenige aussuchen, welches gute Ohmsche Kontakte mit geringen Schottky-Barierenhöhen gewährleistet. Insbesondere wird der Fachmann hierzu auch mehrlagige Kontakte aus verschiedenen der genannten Metalle oder Legierungen in Betracht ziehen. Zur Herstellung eines Legierungskontaktes können auch mehrere Metallschichten aufgebracht und anschließend getempert werden.

Ein besonders einfacher Herstellungsprozess des erfindungsgemäßen transparenten Kontaktes ergibt sich aus einer epitaktischen Abscheidung der AlₙGa₁₋ₙAsₘSb₁₋ₘ - enthaltenden Barrierenschicht und/oder der InₓGa₁₋ₓAs_{y}Sb_{1-y}-enthaltenden Kontaktschicht.

Aufgrund der im Vergleich zur Barrierenschicht guten Ätzbarkeit der Kontaktschicht ist es in einfacher Weise möglich, die Kontaktschicht nachträglich in vorbestimmten Flächenbereichen von der Barrierenschicht zu entfernen. Dabei kann ein nass- oder trockenchemisches Ätzverfahren verwendet werden.

Somit kann die ohnehin vorhandene Barrierenschicht zusätzlich als Ätzstoppschicht dienen. Nach dem erfindungsgemäßen Verfahren ist es daher möglich, die Kontaktschicht in einfacher Weise selektiv von der Bauteiloberfläche zu entfernen. Die nach dem Stand der Technik stets vorhanden verluste durch optische Reflexion an der Barrierenschicht oder durch die Absorption von Photonen in der Kontaktschicht werden damit wunschgemäß vermieden. Somit ist auch der optische Wirkungsgrad der erfindungsgemäßen Halbleiterbauelemente im Vergleich zum Stand der Technik deutlich erhöht.

Das Ätzen der Kontaktschicht erfolgt in einer bevorzugten Ausführungsform durch eine Ätzlösung, welche Zitronensäure und/oder Wasserstoffperoxid und/oder Wasser enthält. Besonders bevorzugt ist hierbei eine Lösung, deren erste Komponente Zitronensäure und Wasser im Verhältnis 1 : 1 enthält, welche ihrerseits mit Wasserstoffperoxid als zweite Komponente im Verhältnis 5 1 gemischt wird.

Besonders vorteilhaft ist eine Ausführungsform, bei welcher die von der Kontaktschicht nicht bedeckten Flächenbereiche der Barrierenschicht durch eine vorzugsweise dielektrische Antireflexschicht bedeckt werden. Diese Schicht verringert die Reflexion des ein- bzw. austretenden Lichtes weiter und erhöht auf diese Weise den optischen Wirkungsgrad des Bauelementes. Weiterhin wird die Barrierenschicht durch die Antireflexschicht vor chemischen Angriffen und Oxidation geschützt.

Besonders bevorzugt werden die Eigenschaften der Antireflexschicht an die spektralen Anforderungen des jeweiligen Bauelementes angepasst. Besonders geeignete Materialien für die dielektrische Antireflexschicht enthalten TaOₓ und/oder TiO₂ und/oder MgF und/oder ZnS und/oder Al₂O₃ und/oder SiN und/oder SiOₓ. Bei der Anpassung der Antireflexschicht an die spektralen Eigenschaften wird der Fachmann insbesondere auch eine Kombination aus mehreren Schichten unterschiedlicher Materialen in Betracht ziehen.

Ohne Beschränkung des allgemeinen Erfindungsgedankens soll die Erfindung nachfolgend anhand eines Ausführungsbeispiels näher erläutert werden:

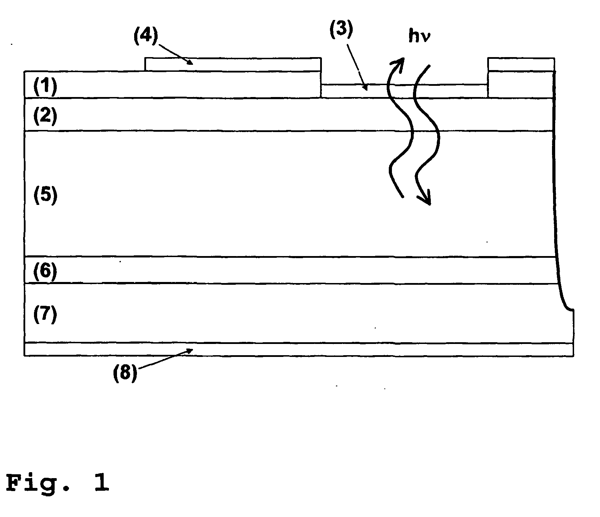

Die beispielhaft beschriebene Thermophotovoltaikzelle weist eine Absorberschichtstruktur 5 aus Galliumantimonid auf, vergl. Figur 1. Diese Absorberschichtstruktur wird in bekannter Weise auf einen Wafer 7 aufgebracht, welcher aus, Galliumantimonid besteht. Eine zwischen Waferoberfläche und Absorber angeordnete Pufferschicht 6 trennt den aktiven Bereich des Bauelementes von den stets auf der Waferoberfläche vorhandenen Verunreinigungen. Auf die Absorberschichtstruktur 5 wird eine transparente Barrierenschicht 2 aus Al_{0.6}Ga_{0.4}As_{0.02}Sb_{0.98} epitaktisch aufgebracht. Die Dicke der Barrierenschicht 2 beträgt dabei etwa 50 nm. Um die entstehenden Ströme abzuleiten, wird das Bauelement mit einer 300 nm dicken Kontaktschicht 1 aus InAs_{0.98}Sb_{0.02} versehen.

In einem nasschemischen Ätzschritt wird diese Kontaktschicht 1 in Teilbereichen des Bauelementes wieder entfernt. Die Teilbereiche sind dabei so ausgewählt, dass der gesamte Wirkungsgrad für die thermophotovoltaische Anwendung, welcher aus dem optischen Wirkungsgrad und dem elektrischen Wirkungsgrad ergibt, maximal wird. Vorliegend sind 10.3 % der Bauteiloberfläche mit der Kontaktschicht belegt.

Zur weiteren Steigerung des optischen Wirkungsgrades und zum Schutz der Barrierenschicht wird auf die freien Bereiche eine mehrlagige Antireflexschicht 3 aus Tantaloxid und Magnesiumfluorid aufgebracht.

Zur verlustarmen Kontaktierung der Kontaktschicht dient ein ebenfalls mehrschichtiger Metallkontakt 4 aus Titan, Nickel und Gold. Auf die Rückseite des Wafers wird ein metallischer, flächiger Rückseitenkontakt 8 aufgebracht.

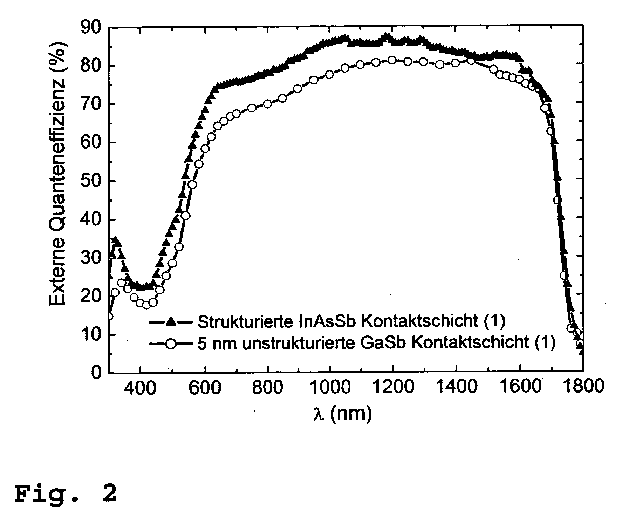

Wie in Fig. 2 dargestellt, erreicht das so hergestellte Bauelement eine Leerlaufspannung von 370 mV und eine Kurzschluss-Stromdichte von 43 mA/cm².

Zum Vergleich wurde eine identische Galliumantimonid-Absorberschicht 5 in gleicher Weise mit einer Al_{0.6}Ga_{0.4}As_{0.02}Sb_{0.98}-Barrierenschicht 2 versehen. Die Kontaktierung erfolgte jedoch nach dem Stand der Technik durch eine nicht strukturierte, nicht-transparente GaSb-Kontaktschicht von 5 nm. Bei hinsichtlich Lichtstärke und spektraler Zusammensetzung identischen Beleuchtungsbedingungen erreichte das so hergestellte Bauelement eine Leerlaufspannung von lediglich 316 mV und bei Kurzschluss eine Stromdichte von 40 mA/cm².

In Figur 2 ist die Empfindlichkeit des Bauelementes als externe Quanteneffizienz in Abhängigkeit der eingestrahlten Wellenlänge dargestellt. Durch die erfindungsgemäße strukturierte Kontaktschicht wird der Wirkungsgrad wunschgemäß im Bereich von 300 nm bis 1600 nm gesteigert.

### Bezugszeichenliste

- 1.: Kontaktschicht
- 2.: Barrierenschicht
- 3.: Antireflexschicht
- 4.: Metall- oder Legierungsschicht
- 5.: Absorberschicht/Substrat
- 6.: Pufferschicht
- 7.: Wafer
- 8.: Rückseitenkontakt

## Patentansprüche

1. Verfahren zur Herstellung eines transparenten, niederohmigen Kontaktes auf einem Substrat (5), bei welchem eine Schichtenabfolge aus einer ersten Schicht, einer zweiten Schicht und einer dritten Schicht auf das Substrat (5) aufgebracht wird, wobei in dem Substrat (5) Licht in elektrische Energie und/oder umgekehrt umgewandelt werden kann, wobei die erste Schicht (2) aus einem AlₙGa₁₋ₙAsₘSb₁₋ₘ enthaltenden Material hergestellt wird, worauf in vorbestimmten Raumbereichen, die eine Teilfläche des Substrats (5) bilden, eine InₓGa₁₋ₓAs_{y}Sb_{1-y} enthaltende Schicht (1) aufgebracht wird und die InₓGa₁₋ₓAs_{y}Sb_{1-y} enthaltenden Bereiche der zweiten Schicht zumindest teilweise mit einer Schicht (4) aus einem Metall oder einer Legierung versehen werden, **dadurch gekennzeichnet, daß** die Parameter x und y aus dem Intervall von 0.9 bis 1.0, der Parameter n aus dem Intervall von 0.3 bis 1 und der Parameter m aus dem Intervall von 0.0 bis 0.1 ausgewählt sind.

2. Verfahren nach Anspruch 1, **dadurch gekennzeichnet, dass** es auf einem GaSb und/oder InAs und/oder GaInAsSb und/oder AlGaAsSb enthaltendem Substrat (5) ausgeführt wird.

3. Verfahren nach einem der Ansprüche 1 bis 2, **dadurch gekennzeichnet, dass** in den Raumbereichen, welche nicht von der InₓGa₁₋ₓAs_{y}Sb_{1-y} enthaltenden Schicht bedeckt sind, zumindest teilweise eine Antireflexschicht (3) aus einem ein Dielektrikum enthaltendem Material aufgebracht wird.

4. Verfahren nach Anspruch 3, **dadurch gekennzeichnet, dass** die Antireflexschicht (3) aus einem TaOₓ und/oder TiO₂/ und/oder MgF und/oder ZnS und/oder Al₂O₃ und/oder SiN und/oder SiOₓ enthaltenden Material hergestellt wird.

5. Verfahren nach einem der Ansprüche 1 bis 4, **dadurch gekennzeichnet, dass** die Schicht (4) aus einem Metall oder einer Legierung aus Gold und/oder Titan und/oder Platin und/oder Nickel und/oder Palladium und/oder Zink und/oder Silber und/oder Germanium enthaltendem Material hergestellt wird.

6. Verfahren nach einem der Ansprüche 1 bis 5, **dadurch gekennzeichnet, dass** auf die Schicht aus einem Metall oder einer Legierung mindestens eine weitere Schicht aufgebracht wird.

7. Verfahren nach Anspruch 6, **dadurch gekennzeichnet, dass** die Schicht aus einem Metall oder einer Legierung getempert wird.

8. Verfahren nach einem der Ansprüche 1 bis 7, **dadurch gekennzeichnet, dass** die InₓGa₁₋ₓAs_{y}Sb_{1-y} enthaltende Schicht zumindest in den Raumbereichen entfernt wird, in welchen die Antireflexschicht (3) aufgebracht werden soll.

9. Verfahren nach Anspruch 8, **dadurch gekennzeichnet, dass** die Entfernung der InₓGa₁₋ₓAs_{y}Sb_{1-y} enthaltenden Schicht durch Ätzen erfolgt.

10. Verfahren nach Anspruch 9, **dadurch gekennzeichnet, dass** das Ätzen durch eine Zitronensäure und/oder Wasserstoffperoxyd und/oder Wasser enthaltende Lösung erfolgt.

11. Verfahren nach einem der Ansprüche 1 bis 10, **dadurch gekennzeichnet, dass** das AlₙGa₁₋ₙAsₘSb₁₋ₘ und/oder das InₓGa₁₋ₓAs_{y}Sb_{1-y} enthaltende Material mit einem Dotierstoff versehen wird.

12. Verfahren nach Anspruch 11, **dadurch gekennzeichnet, dass** der Dotierstoff ausgewählt ist unter Silizium und/oder Schwefel und/oder Tellur und/oder Kohlenstoff und/oder Magnesium und/oder Zink und/oder Selen.

13. Verfahren nach einem der Ansprüche 1 bis 12, **dadurch gekennzeichnet, dass** das AlₙGa₁₋ₙAsₘSb₁₋ₘ und/oder das InₓGa₁₋ₓAs_{y}Sb_{1-y} enthaltende Material epitaktisch abgeschieden werden.

14. Transparenter, niederohmiger Kontakt auf einem Substrat (5), welcher eine Schichtenabfolge aus einer ersten Schicht, einer zweiten Schicht und einer dritten Schicht auf einem Substrat (5) umfasst, wobei in dem Substrat (5) Licht in elektrische Energie und/oder umgekehrt umgewandelt werden kann, wobei die erste Schicht (2) AlₙGa₁₋ₙAsₘSb₁₋ₘ enthält, welche in vorbestimmten Raumbereichen, die eine Teilfläche des Substrats (5) bilden, mit einer InₓGa₁₋ₓAs_{y}Sb_{1-y} enthaltenden Schicht (1) versehen ist auf welcher zumindest teilweise eine Schicht (4) aus einem Metall oder einer Legierung aufgebracht ist, **dadurch gekennzeichnet, daß** die Parameter x und y aus dem Intervall von 0.9 bis 1.0, der Parameter n aus dem Intervall von 0.3 bis 1 und der Parameter m aus dem Intervall von 0.0 bis 0.1 ausgewählt sind.

15. Kontakt nach Anspruch 14, **dadurch gekennzeichnet, dass** das Substrat (5) GaSb und/oder InAs und/oder GaInAsSb und/oder AlGaAssb enthält.

16. Kontakt nach Anspruch 15, **dadurch gekennzeichnet, dass** das Substrat (5) eine GaₓIn₁₋ₓAs_{y}Sb_{1-y} enthaltende Schicht auf einer GaSb enthaltenden Schicht aufweist.

17. Kontakt nach einem der Ansprüche 14 bis 16, **dadurch gekennzeichnet, dass** in den Raumbereichen, welche nicht von der InₓGa₁₋ₓAs_{y}Sb_{1-y} enthaltenden Schicht (1) bedeckt sind, zumindest teilweise eine Antireflexschicht (3) aufgebracht ist.

18. Kontakt nach Anspruch 17, **dadurch gekennzeichnet, dass** die Antireflexschicht (3) TaOₓ und/oder TiO₂/ und/oder MgF und/oder ZnS und/oder Al₂O₃ und/oder SiN und/oder SiOₓ enthält.

19. Kontakt nach einem der Ansprüche 14 bis 17, **dadurch gekennzeichnet, dass** die Antireflexschicht (3) mehrere Schichten umfasst.

20. Kontakt nach einem der Ansprüche 14 bis 19, **dadurch gekennzeichnet, dass** die mindestens eine Schicht (4) aus einem Metall oder einer Legierung Gold und/oder Titan und/oder Platin und/oder Nickel und/oder Palladium und/oder Zink und/oder Silber und/oder Germanium enthält.

21. Kontakt nach einem der Ansprüche 14 bis 20, **dadurch gekennzeichnet, dass** das AlₙGa₁₋ₙAsₘSb₁₋ₘ und/oder das InxGa₁₋ₓAs_{y}Sb_{1-y} enthaltende Material mit einem Dotierstoff versehen ist.

22. Kontakt nach Anspruch 21, **dadurch gekennzeichnet, dass** der Dotierstoff ausgewählt ist unter Silizium und/oder Schwefel und/oder Tellur und/oder Kohlenstoff und/oder Magnesium und/oder Zink und/oder Selen.

23. Verwendung eines Kontakt nach einem der Ansprüche 14 bis 22 in einer thermophotovoltaischen Zelle.

24. Verwendung eines Kontakt nach einem der Ansprüche 14 bis 22 in einem Halbleiterlaser oder einer Leuchtdiode.

25. Verwendung eines Kontakt nach einem der Ansprüche 14 bis 22 in einem Infrarot-Photodetektor.

26. Verwendung eines Kontakt nach einem der Ansprüche 14 bis 22 in einem Gassensor.

## Claims

1. Method for producing a transparent, low-resistance contact on a substrate (5), in which a layer sequence made up of a first layer, a second layer and a third layer is applied to the substrate (5), light being able to be converted in the substrate (5) into electrical energy and/or vice versa, the first layer (2) being produced from a material containing AlₙGa₁₋ₙAsₘSb₁₋ₘ, onto which in predetermined spatial regions, which form a partial surface of the substrate (5), a layer (1) containing InₓGa₁₋ₓAs_{y}Sb_{1-y} is applied and the regions containing InₓGa₁₋ₓAs_{y}Sb_{1-y} of the second layer being at least partially provided with a layer (4) made of a metal or an alloy, **characterised in that** the parameters x and y are selected from the interval 0.9 to 1.0, the parameter n from the interval 0.3 to 1 and the parameter m from the interval 0.0 to 0.1.

2. Method according to Claim 1, **characterised in that** it is implemented on a substrate (5) containing GaSb and/or InAs and/or GaInAsSb and/or AlGaAsSb.

3. Method according to one of Claims 1 to 2, **characterised in that** in the spatial regions which are not covered by the layer containing InₓGa_{1- x}AS_{y}Sb_{1-y}, an anti-reflection layer (3) made of a material containing a dielectricum is at least partially applied.

4. Method according to Claim 3, **characterised in that** the anti-reflection layer (3) is produced from a material containing TaOₓ and/or TiO₂/and/or MgF and/or ZnS and/or Al₂O₃ and/or SiN and/or SiOₓ.

5. Method according to one of Claims 1 to 4, **characterised in that** the layer (4) made of a metal or an alloy is produced from material containing gold and/or titanium and/or platinum and/or nickel and/or palladium and/or zinc and/or silver and/or germanium.

6. Method according to one of Claims 1 to 5, **characterised in that** at least one further layer is applied to the layer made of a metal or an alloy.

7. Method according to Claim 6, **characterised in that** the layer made of a metal or an alloy is tempered.

8. Method according to one of Claims 1 to 7, **characterised in that** the layer containing InₓGa₁₋ₓAs_{y}Sb_{1-y} is removed at least in the spatial regions in which the antireflection layer (3) is intended to be applied.

9. Method according to Claim 8, **characterised in that** the removal of the layer containing the InₓGa₁₋ₓAs_{y}Sb_{1-y} is carried out by etching.

10. Method according to Claim 9, **characterised in that** the etching is carried out by a solution containing citric acid and/or hydrogen peroxide and/or water.

11. Method according to one of Claims 1 to 10, **characterised in that** the material containing AlₙGa₁₋ₙAsₘSb₁₋ₘ and/or the material containing InₓGa₁₋ₓAs_{y}Sb_{1-y} is provided with a doping material.

12. Method according to Claim 11, **characterised in that** the doping material is selected from silicon and/or sulphur and/or tellurium and/or carbon and/or magnesium and/or zinc and/or selenium.

13. Method according to one of Claims 1 to 12, **characterised in that** the material containing AlₙGa₁₋ₙAsₘSb₁₋ₘ and/or the material containing InₓGa₁₋ₓAs_{y}Sb_{1-y} is epitaxically grown.

14. Transparent, low-resistance contact on a substrate (5), which comprises a layer sequence made up of a first layer, a second layer and a third layer on a substrate (5), light being able to be converted in the substrate (5) into electrical energy and/or vice versa, the first layer (2) containing AlₙGa_{1- n}AsₘSb₁₋ₘ which in predetermined spatial regions, which form a partial surface of the substrate (5), is provided with a layer (1) containing InₓGa_{1- x}As_{y}Sb_{1-y} on which at least partially a layer (4) made of a metal or an alloy is applied, **characterised in that** the parameters x and y are selected from the interval 0.9 to 1.0, the parameter n from the interval 0.3 to 1 and the parameter m from the interval 0.0 to 0.1.

15. Contact according to claim 14, **characterised in that** the substrate (5) contains GaSb and/or InAs and/or GaInAsSb and/or AlGaAsSb.

16. Contact according to Claim 15, **characterised in that** the substrate (5) comprises a layer containing GaₓIn₁₋ₓAs_{y}Sb_{1-y} on a layer containing GaSb.

17. Contact according to one of Claims 14 to 16, **characterised in that** in the spatial regions which are not covered by the layer (1) containing InₓGa_{1- x}As_{y}Sb_{1-y}, an anti-reflection layer (3) is at least partially applied.

18. Contact according to Claim 17, **characterised in that** the anti-reflection layer (3) contains TaOₓ and/or TiO₂/and/ MgF and/or ZnS and/or Al₂O₃ and/or SiN and/or SiOₓ

19. Contact according to one of Claims 14 to 17, **characterised in that** the anti-reflection layer (3) contains a plurality of layers.

20. Contact according to one of Claims 14 to 19, **characterised in that** the at least one layer (4) made of a metal or an alloy, contains gold and/or titanium and/or platinum and/or nickel and/or palladium and/or zinc and/or silver and/or germanium.

21. Contact according to one of Claims 14 to 20, **characterised in that** the material containing AlₙGa₁₋ₙAsₘSb₁₋ₘ and/or the material containing InₓGa₁₋ₓAs_{y}Sb_{1-y} is provided with a doping material.

22. Contact according to Claim 21, **characterised in that** the doping material is selected from silicon and/or sulphur and/or tellurium and/or carbon and/or magnesium and/or zinc and/or selenium.

23. Use of a contact according to one of Claims 14 to 22 in a thermophotovoltaic cell.

24. Use of a contact according to one of Claims 14 to 22, in a semiconductor laser or a light-emitting diode.

25. Use of a contact according to one of Claims 14 to 22, in an infrared photodetector.

26. Use of a contact according to one of Claims 14 to 22 in a gas sensor.

## Revendications

1. Procédé de fabrication d'un contact transparent de basse impédance (5) sur un substrat, pour lequel on applique une succession de couches consistant dans une première couche, une deuxième couche et une troisième couche sur le substrat (5), de la lumière pouvant être transformée en énergie électrique et/ou inversement dans le substrat (5), la première couche (2) étant fabriquée en une matière contenant de l'AlₙGa₁₋ₙAsₘSb₁₋ₘ sur laquelle, dans des zones d'espace prédéfinies qui forment une surface partielle du substrat (5), on applique une couche (1) contenant de l'InₓGa_{1- x}As_{y}Sb_{1-y} et on munit les zones de la deuxième couche contenant de l'InₓGa₁₋ₓAs_{y}Sb_{1-y} au moins partiellement d'une couche (4) en un métal ou en un alliage, **caractérisé en ce que** les paramètres x et y sont choisis dans l'intervalle de 0.9 à 1.0, le paramètre n dans l'intervalle de 0.3 à 1 et le paramètre m dans l'intervalle de 0.0 à 0.1.

2. Procédé selon la revendication 1, **caractérisé en ce qu'**on le réalise sur un substrat (5) contenant du GaSb et/ou de l'InAs et/ou du GaInAsSb et/ou de l'AlGaAsSb.

3. Procédé selon l'une quelconque des revendications 1 à 2, **caractérisé en ce que** dans les zones de l'espace qui ne sont pas recouvertes par la couche contenant de l'InₓGa₁₋ₓAs_{y}Sb_{1-y}, on applique au moins en partie (3) une matière contenant une matière diélectrique.

4. Procédé selon la revendication 3, **caractérisé en ce qu'**on fabrique la couche antiréflexion (3) en une matière contenant du TaOₓ et/ou du Ti0₂/ et/ou du MgF et/ou du ZnS et/ou de l'Al₂O₃ et/ou du SiN et/ou du SiOₓ.

5. Procédé selon l'une quelconque des revendications 1 à 4, **caractérisé en ce qu'**on fabrique la couche (4) en une matière contenant un métal ou un alliage d'or et/ou de titane et/ou de platine et/ou de nickel et/ou de palladium et/ou de zinc et/ou d'argent et/ou de germanium.

6. Procédé selon l'une quelconque des revendications 1 à 5, **caractérisé en ce qu'**on applique au moins une couche supplémentaire sur la couche en un métal ou un alliage.

7. Procédé selon la revendication 6, **caractérisé en ce qu'**on malléabilise la couche en un métal ou un alliage.

8. Procédé selon l'une quelconque des revendications 1 à 7, **caractérisé en ce qu'**on retire la couche contenant de l'InₓGal-ₓAs_{y}Sb_{1-y} au moins dans les zones dans l'espace sur lesquelles la couche antiréflexion (3) doit être appliquée.

9. Procédé selon la revendication 8, **caractérisé en ce que** le retrait de la couche contenant de l'InₓGa₁₋ₓAs_{y}Sb_{1-y} s'effectue par mordançage.

10. Procédé selon la revendication 9, **caractérisé en ce que** le mordançage s'effectue à l'aide d'une solution contenant de l'acide citrique et/ou du peroxyde d'hydrogène et/ou de l'eau.

11. Procédé selon l'une quelconque des revendications 1 à 10, **caractérisé en ce qu'**on munit la manière contenant de l'AlₙGa₁₋ₙAsₘSb₁₋ₘ et/ou de l'InₓGa_{1- x}As_{y}Sb_{1-y} d'un dope.

12. Procédé selon la revendication 11, **caractérisé en ce qu'**on choisit le dope parmi le silicium et/ou le soufre et/ou le tellure et/ou le carbone et/ou le magnésium et/ou le zinc et/ou le sélénium.

13. Procédé selon l'une quelconque des revendications 1 à 12, **caractérisé en ce qu'**on sépare de façon épitaxiale la matière contenant de l'AlₙGa₁₋ₙAsₘSb₁₋ₘ et/ou de l'InₓGa₁₋ₓAs_{y}Sb_{1-y}.

14. Contact transparent de basse impédance sur un substrat (5) comprenant une succession de couches consistant dans une première couche, une deuxième couche et une troisième couche sur un substrat (5), de la lumière pouvant être transformée en énergie électrique et/ou inversement dans le substrat (5), la première couche (2) contenant de l'AlₙGa₁₋ₙAsₘSb₁₋ₘ qui dans des zones de l'espace prédéfinies qui forment une surface partielle du substrat (5) est munie d'une couche (1) contenant de l'InₓGa₁₋ₓAs_{y}Sb_{1-y} et sur laquelle il est appliqué au moins en partie une couche (4) en un métal ou en un alliage, **caractérisé en ce que** les paramètres x et y sont choisis dans l'intervalle de 0.9 à 1.0, le paramètre n dans l'intervalle de 0.3 à 1 et le paramètre m dans l'intervalle de 0.0 à 0.1.

15. Contact selon la revendication 14, **caractérisé en ce que** le substrat (5) contient du GaSb et/ou de l'InAs et/ou du GaInAsSb et/ou de l'AlGaAsSb.

16. Procédé selon la revendication 15, **caractérisé en ce que** le substrat (5) comporte une couche contenant du GaₓIn₁₋ₓAs_{y}Sb_{1-y} ou une couche contenant du Gasb.

17. Produit selon l'une quelconque des revendications 14 à 16, **caractérisé en ce que** dans les zones de l'espace qui ne sont pas recouvertes par la couche (1) contenant de l'InₓGa₁₋ₓAs_{y}Sb_{1-y}, on applique au moins en partie une couche antiréflexion (3).

18. Contact selon la revendication 17, **caractérisé en ce que** la couche antiréflexion (3) contient du TaOₓ et/ou du TiO₂/ et/ou du MgF et/ou du ZnS et/ou de Al₂O₃ et/ou du SiN et/ou du SiOₓ.

19. Contact selon l'une quelconque des revendications 14 à 17, **caractérisé en ce que** la couche antiréflexion (3) comprend plusieurs couches.

20. Contact selon l'une quelconque des revendications 14 à 19, **caractérisé en ce que** la au moins une couche (4) en un métal ou un alliage contient de l'or et/ou du titane et/ou du platine et/ou du nickel et/ou du palladium et/ou du zinc et/ou de l'argent et/ou du germanium.

21. Contact selon l'une quelconque des revendications 14 à 20, **caractérisé en ce que** la matière contenant de l'AlₙGa₁₋ₙAsₘSb₁₋ₘ et/ou de l'InₓGa₁₋ₓAs_{y}Sb_{1-y} est munie d'un dope.

22. Contact selon la revendication 21, **caractérisé en ce qu'**on choisit le dope parmi le silicium et/ou le soufre et/ou le tellure et/ou le carbone et/ou le magnésium et/ou le zinc et/ou le sélénium.

23. Utilisation d'un contact selon l'une quelconque des revendications 14 à 22 dans une cellule thermophotovoltaïque.

24. Utilisation d'un contact selon l'une quelconque des revendications 14 à 22 dans un laser à semiconducteur ou dans une diode électroluminescente.

25. Utilisation d'un contact selon l'une quelconque des revendications 14 à 22 dans un photodétecteur à infrarouge.

26. Utilisation d'un contact selon l'une quelconque des revendications 14 à 22 dans un capteur de gaz.
